# EUROPÄISCHE PATENTANMELDUNG

(11) **EP 1 691 309 A1**
(43) Veröffentlichungstag der Anmeldung: **16.08.2006**
(21) Anmeldenummer: 05002709.3
(22) Anmeldetag: 09.02.2005
(51) Int. Cl.: G06F 17/50

(54) **Kontextsensitive Benutzerhilfe in einer softwarebasierten Entwicklungsumgebung**

(71) Anmelder: SIEMENS AKTIENGESELLSCHAFT, 80333 München (DE)
(72) Erfinder: Kreiner, Georg, 92260 Ammerthal (DE)

(57) **Zusammenfassung**

Die Erfindung betrifft ein Verfahren, ein System und ein Computerprogrammprodukt zur Bereitstellung von Benutzerinformationen innerhalb einer softwarebasierten Entwicklungsumgebung zum Entwurf von aus funktionalen Einheiten aufgebauten Schaltungen und/oder Systemen. Um eine kontextsensitive und für einen Anwender schnell auffassbare Hilfestellung bereitzustellen, werden folgende Verfahrensschritte vorgeschlagen:
- Erkennen einer von einem Anwender selektierten funktionalen Einheit,
- Darstellung einer Demonstrationsapplikation, innerhalb derer die selektierte funktionale Einheit enthalten ist,
- Simulation der Demonstrationsapplikation und
- Visualisierung der Simulationsergebnisse.

## Beschreibung

Die Erfindung betrifft ein Verfahren, ein Computerprogrammprodukt und ein System zur Bereitstellung von Benutzerinformationen innerhalb einer softwarebasierten Entwicklungsumgebung zum Entwurf von aus funktionalen Einheiten aufgebauten Schaltungen und/oder Systemen.

Derartige Entwicklungsumgebungen sind beispielsweise Schaltungssimulationsprogramme, bei denen elektrische funktionale Einheiten (z. B. Widerstand, Kapazität...), elektronische (z. B. Diode, MOSFET...), logische (z. B. AND-Gatter, Inverter...) oder auch pneumatische (z. B. Ventil...) Funktionseinheiten bei einem Schaltungsentwurf von einem Anwender kombiniert werden können. Die resultierende Schaltung kann anschließend simuliert werden, um eine gewünschte Funktionalität zu überprüfen.

Bei einer Systemsimulation werden häufig komplexe Systeme aus einzelnen Subsystemen aufgebaut. Auch hierbei kann die Erfindung zum Einsatz kommen, um einem Anwender Informationen beim Entwurf des Gesamtsystems zu den einzelnen funktionalen Einheiten - den Subsystemen - bereitzustellen.

Als weiteres Einsatzgebiet sind grafikbasierte Programmierumgebungen zu nennen, bei denen insbesondere Steuerungsprogramme mit Hilfe einer grafischen Benutzeroberfläche durch ein Verschalten funktionaler Einheiten generiert werden.

Von einer Entwicklungsumgebung bereitgestellte funktionale Einheiten können u. U. eine sehr komplexe Funktionalität aufweisen. Daher werden von der Entwicklungsumgebung meist entsprechende Hilfetexte zu den zur Verfügung stehenden Funktionsblöcken bereitgestellt.

Der Erfindung liegt die Aufgabe zu Grunde, in einer softwarebasierten Entwicklungsumgebung eine kontextsensitive und für einen Anwender schnell auffassbare Hilfestellung bereitzustellen.

Diese Aufgabe wird durch ein Verfahren gelöst zur Bereitstellung von Benutzerinformationen innerhalb einer softwarebasierten Entwicklungsumgebung zum Entwurf von aus funktionalen Einheiten aufgebauten Schaltungen und/oder Systemen mit folgenden Verfahrensschritten:
- Erkennen einer von einem Anwender selektierten funktionalen Einheit,
- Darstellung einer Demonstrationsapplikation, innerhalb derer die selektierte funktionale Einheit enthalten ist,
- Simulation der Demonstrationsapplikation und
- Visualisierung der Simulationsergebnisse.

Weiterhin wird die Aufgabe durch ein Computerprogrammprodukt zur Durchführung eines derartigen Verfahrens gelöst.

Ferner wird diese Aufgabe durch ein System gelöst zur Bereitstellung von Benutzerinformationen mit einem Speicher für eine softwarebasierte Entwicklungsumgebung zum Entwurf von aus funktionalen Einheiten aufgebauten Schaltungen und/oder Systemen, wobei das System
- Mittel zum Erkennen einer von einem Anwender selektierten funktionalen Einheit,
- Mittel zur Darstellung einer Demonstrationsapplikation, innerhalb derer die selektierte funktionale Einheit enthalten ist,
- Mittel zur Simulation der Demonstrationsapplikation und
- Mittel zur Visualisierung der Simulationsergebnisse aufweist.

Der Erfindung liegt die Erkenntnis zugrunde, das es vielfach schwierig ist, komplexe Funktionen für einen Anwender leicht verständlich und in kurzer Form zu beschreiben. Daher neigen viele Anwender dazu, bei ihrer Arbeit in der Entwicklungsumgebung neue, für sie unbekannte Funktionen eher auszutesten, als langwierige Beschreibungstexte zu diesen Funktionen zu lesen.

Bei dem erfindungsgemäßen Verfahren hat der Anwender die Möglichkeit, anhand einer Demonstrationsapplikation die Funktionalität einer ausgewählten funktionalen Einheit selbst auszuprobieren. Dies kann z.B. folgendermaßen innerhalb der Entwicklungsumgebung realisiert werden. Selektiert der Anwender eine funktionale Einheit innerhalb seiner Benutzeroberfläche, so hat er die Möglichkeit, z.B. über die Bedienung der rechten Maustaste eine Demonstrationsapplikationen zu öffnen, innerhalb derer die selektierte funktionale Einheit ein zentrales Element darstellt. Der Anwender kann die Demonstrationsapplikation modifizieren und anschließend simulieren, wobei die Ergebnisse der Simulation visualisiert werden. Auf diese Art und Weise erlernt der Anwender quasi spielerisch die Funktion des von ihm ausgewählten Bausteins. Das Lesen einer langen Dokumentation ist hierbei hinfällig.

Beispielsweise ist eine derartige softwarebasierte Entwicklungsumgebung zum Entwurf elektrischer, elektronischer und/oder logischer Schaltung vorgesehen. Es kann sich hierbei z.B. um Schaltungssimulationsprogramme handeln. Innerhalb dieser Schaltungssimulationsprogramme kann ein Anwender in einer grafischen Benutzeroberfläche einen elektrischen, elektronischen und/oder logischen Schaltplan erstellen, in dem er entsprechende funktionale Einheiten miteinander verbindet. Bei den funktionalen Einheiten handelt es sich beispielsweise um elektrische oder elektronische Bauteile bzw. logische Funktionsblöcke, wie ein AND- oder ein OR-Gatter oder ein Inverter. Die auf diese Weise erstellte Schaltung lässt sich anschließend simulieren, und die Ergebnisse der Simulation werden für den Anwender auf einen Bildschirm dargestellt.

Alternativ kann die softwarebasierte Entwicklungsumgebung zum Entwurf von Steuerung und/oder Regelung vorgesehen sein. Bei dem Entwurf von Regelkreisen werden Funktionsblöcke, die eine spezielle Übertragungsfunktion repräsentieren, miteinander verbunden. Eine Erläuterung zu einem selektierten Funktionsblock wird dem Anwender in Form eines Demonstrationsblockdiagramms gegeben, in dem der Funktionsblock eine zentrale Rolle spielt. Das Demonstrationsblockdiagramm kann von dem Anwender simuliert werden. Ein- und Ausgänge der Funktionsblöcke innerhalb des Blockdiagramms können visualisiert werden, so dass der Anwender durch ausprobieren die Funktionalität des gewählten Blocks verstehen kann.

In einer vorteilhaften Ausführungsform des erfindungsgemäßen Verfahrens wird vor einem Start der Simulation ein Dialogfeld geöffnet, innerhalb dessen der Anwender den Wert mindestens eines Parameters modifizieren kann, der Einfluss auf die Simulationsergebnisse hat. Auf diese Art und Weise ist der Anwender in der Lage, den Ablauf der Simulation selbst zu beeinflussen. Er kann aktiv die Funktionalitäten des gewählten Funktionsblocks austesten. Insbesondere hierzu ist es vorteilhaft, wenn der Parameter das Verhalten der selektierten funktionalen Einheit beeinflusst.

Zweckmäßigerweise ist die selektierte funktionale Einheit über Ein- und/oder Ausgänge mit weiteren funktionalen Einheiten in der Demonstrationsapplikation verbunden, wobei die Zustände der Ein- und/oder Ausgänge während und/oder nach der Simulation visualisiert werden. Denkbar ist beispielsweise, dass sich während der Simulation ein Fenster öffnet, innerhalb dessen die Ergebnisse der Simulation über der Zeit aufgetragen werden. Bei der Simulation einer elektrischen oder elektronischen Schaltung wäre hier z.B. denkbar, dass es sich bei den Simulationsergebnissen um Potenziale an den Ein- und Ausgängen der selektierten funktionalen Einheit handelt.

Um dem Anwender beim Umgang mit der Demonstrationsapplikation besonders viel Freiraum zu gewähren, ist es eine zweckmäßige Ausführung der Erfindung dadurch gekennzeichnet, dass die Demonstrationsapplikation durch den Anwender insbesondere durch hinzufügen und/oder entfernen der funktionalen Einheiten und/oder durch Zustandsänderungen an Eingängen der funktionalen Einheiten modifizierbar ist. Handelt es sich bei der Demonstrationsapplikation beispielsweise um eine logische Schaltung, so können von dem Anwender beliebige Funktionsblöcke hinzugefügt oder entfernt werden, um so Rückschlüsse auf die Funktion eines selektierten Funktionsblocks ziehen zu können.

Zusätzlich zu der Erläuterung der Funktionalität der gewählten funktionalen Einheit in Form einer von dem Anwender beeinflussbaren Demonstrationsapplikation kann es sinnvoll sein, dass bei der Darstellung der Demonstrationsapplikation und/oder bei der Visualisierung der Simulationsergebnisse eine text- und/oder grafikbasierte Erläuterung zu der selektierten funktionalen Einheit angezeigt wird. Eine derartige text- und/oder grafikbasierte Erläuterung muss nicht so ausführlich sein, wie es bei einer herkömmlichen Entwicklungsumgebung der Fall wäre. Die zusätzliche Erläuterung dient lediglich dazu, Funktionalitäten des gewählten Blocks zu erläutern, die anhand der Darstellung der Simulation nicht vermittelbar sind.

Die selektierte funktionale Einheit, kann entweder ein inhärenter Bestandteil der Entwicklungsumgebung sein oder eine benutzerdefinierte funktionale Einheit sein, die insbesondere aus weiteren funktionalen Einheiten aufgebaut ist, die inhärente Bestandteile der Entwicklungsumgebung sind. Somit ist auch denkbar und von der Erfindung umfasst, dass ein Anwender eine funktionale Einheit selbst aufbaut und zu der Entwicklungsumgebung als Baustein hinzufügt. Er kann auch zu diesem Baustein eine Demonstrationsapplikation entwickeln und in die Entwicklungsumgebung einbinden, anhand derer einem weiteren Anwender die Funktionalität dieser Baugruppe vermittelt werden kann.

Im Folgenden wird die Erfindung anhand der in den Figuren dargestellten Ausführungsbeispiele näher beschrieben und erläutert. Es zeigen:
- FIG 1: eine Benutzeroberfläche einer Entwicklungsumgebung, bei der das erfindungsgemäße Verfahren zum Einsatz kommt,
- FIG 2: eine weitere Benutzeroberfläche zur Erzeugung einer Entwicklungsumgebung, bei der das erfindungsgemäße Verfahren zum Einsatz kommt und
- FIG 3: eine erfindungsgemäße Ausführungsform eines Systems zur Bereitstellung von Nutzerinformationen innerhalb einer softwarebasierten Entwicklungsumgebung.

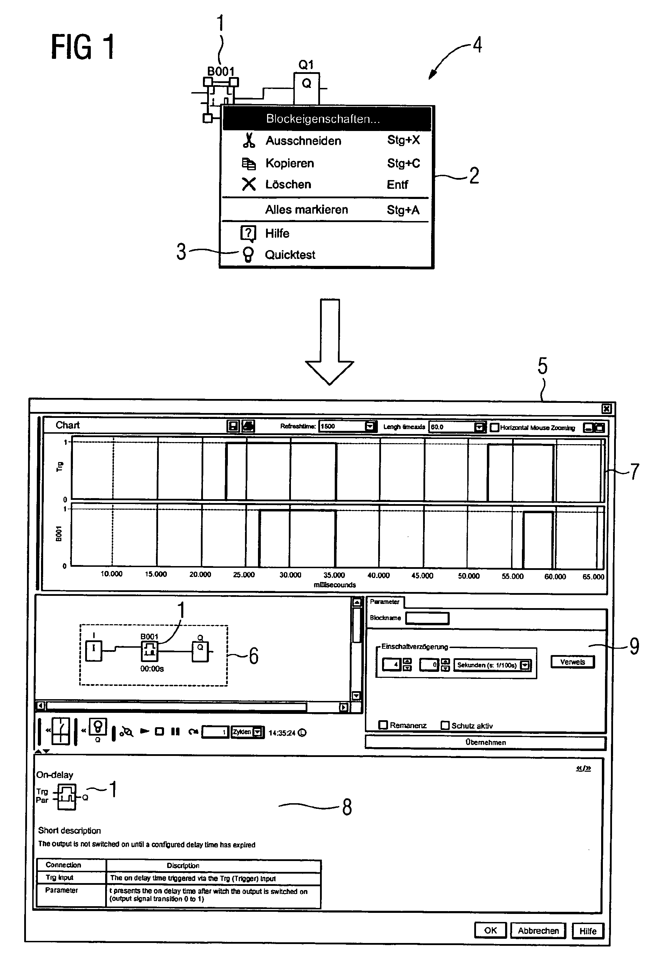

FIG 1 zeigt eine Benutzeroberfläche 4 einer Entwicklungsumgebung, bei der das erfindungsgemäße Verfahren zum Einsatz kommt. Bei der dargestellten Entwicklungsumgebung handelt es sich um eine grafische Programmierumgebung, innerhalb der der Benutzer eine logische Schaltung definieren kann. Die logische Schaltung besteht aus einzelnen funktionalen Einheiten, im Folgenden auch Funktionsblöcke genannt, die sich der Anwender aus einer Funktionsleiste auf den Bildschirm ziehen und miteinander verdrahten kann. Die einzelnen Funktionsblöcke 1 stellen Elemente einer logischen Schaltung dar, z.B. ein AND-Gatter, ein OR-Gatter oder auch ein Inverter. Eine so aufgebaute Schaltung kann der Anwender innerhalb der Entwicklungsumgebung zunächst simulieren, um die korrekte Funktionalität der Schaltung zu überprüfen. Anschließend kann der Anwender basierend auf der logischen Schaltung automatisch einen Steuerungscode generieren lassen, der auf ein entsprechendes Steuerungsgerät geladen werden kann.

Innerhalb der grafischen Benutzeroberfläche 4 selektiert der Anwender eine funktionale Einheit 1, in dem Beispiel ein Verzögerungsglied, mit dem Mauszeiger. Durch betätigen der rechten Maustaste öffnet der Anwender ein Menü 2 zu der selektierten funktionalen Einheit 1. Innerhalb des Menüs 2 befindet sich ein Button 3, durch dessen Betätigung ein weiteres Fenster 5 geöffnet wird. Innerhalb des weiteren Fensters 5 ist eine als logische Schaltung ausgebildete Demonstrationsapplikation 6 dargestellt, in der die von dem Anwender selektierte funktionale Einheit 1 einen zentralen Baustein bildet. Die Demonstrationsapplikation 6 kann von dem Anwender simuliert werden. Um Einfluss auf die Simulation nehmen zu können, hat der Anwender die Möglichkeit, in einem Parameterfeld 9 die Simulation beeinflussende Parameter zu modifizieren. Auf diese Art und Weise hat der Anwender die Möglichkeit, durch Variation der Parameter die Funktionalitäten der selektierten Einheit 1, des Verzögerungsgliedes, durch ausprobieren kennen zu lernen. Darüber hinaus kann der Anwender sogar die Demonstrationsapplikation 6 verändern, indem er weitere funktionale Einheiten in das weitere Fenster 5 z. B. mit der Maus platziert und diese mit der Demonstrationsapplikation 6 verbindet. Ferner kann er auch die Eingangszustände der in der Demonstrationsapplikation 6 enthaltenen Funktionsblöcke beeinflussen.

Sobald der Anwender die Simulation der Demonstrationsapplikation 6 startet, werden in einem oberen Bereich des Fensters 5 die Simulationsergebnisse 7 dargestellt. Hier werden die Zustände der Ein- und Ausgänge der selektierten funktionalen Einheit 1 über der Zeit aufgezeigt.

Zusätzlich zu der Darstellung der Demonstrationsschaltung 6 und der Simulationsergebnisse 7 innerhalb des Fensters 5 wird in einen unteren Bereich des Fensters 5 ein Erklärungstext 8 zu der selektierten funktionalen Einheit 1 dargestellt. Dieser Erklärungstext 8 ist sehr kurz gehalten, da der Anwender die wesentlichen Merkmale der selektierten funktionalen Einheit 1 bei dem erfindungsgemäßen Verfahren durch Ausprobieren kennen lernen kann. Somit wird von dem Anwender kein zeitaufwendiges Lesen langer Dokumentationen erwartet.

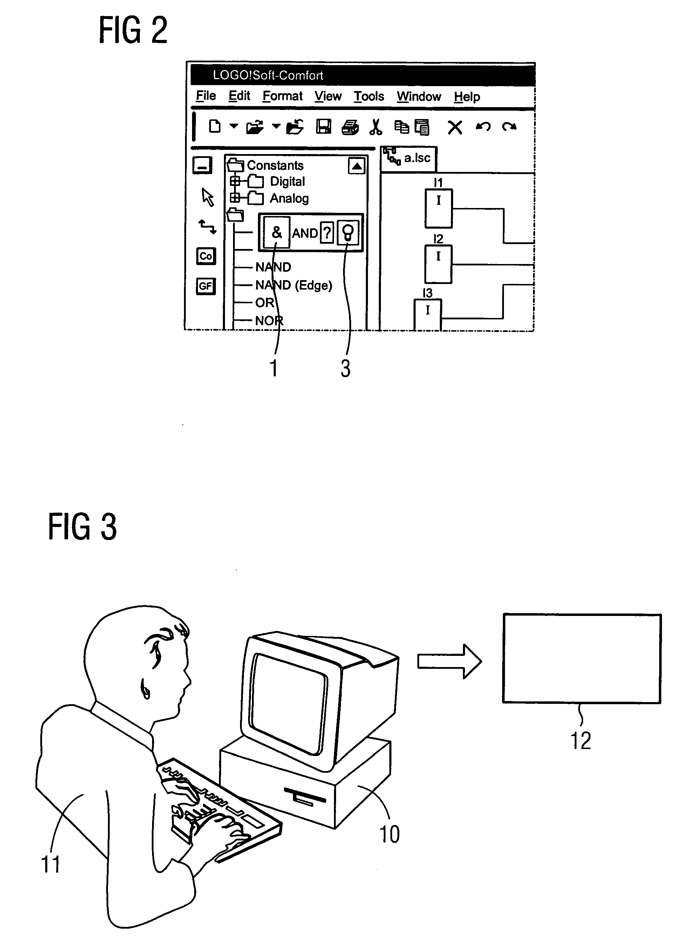

FIG 2 zeigt eine weitere Benutzeroberfläche zur Erzeugung einer Entwicklungsumgebung, bei der das erfindungsgemäße Verfahren zum Einsatz kommt. Bei der hier dargestellten Ausführungsform sind funktionale Einheiten 1, aus denen sich logische Schaltungen generieren lassen, in einer Baumstruktur abgelegt. Die funktionalen Einheiten 1 stellen wiederum logische Funktionen dar, die zu einem Schaltplan verbunden werden können. In dem gezeigten Beispiel markiert ein Anwender insbesondere mit dem Mauszeiger eine funktionale Einheit 1 innerhalb der Baumstruktur, um sie in eine logische Schaltung zu integrieren. Hierbei öffnet sich ein Fenster, welches ihm zeigt, dass die gewählte funktionale Einheit ein AND-Gatter darstellt. Ferner wird ein Button eingeblendet, mit dem eine Demonstrationsapplikation geöffnet werden kann, anhand derer die Funktion des AND-Gatters aufgezeigt wird.

FIG 3 zeigt eine erfindungsgemäße Ausführungsform eines Systems zur Bereitstellung von Benutzerinformationen innerhalb einer softwarebasierten Entwicklungsumgebung. Das System weist eine Datenverarbeitungsanlage 10 auf, auf der eine Entwicklungsumgebung zum Entwurf von aus funktionalen Einheiten aufgebauten Schaltungen installiert ist. Mit Hilfe dieser Entwicklungsumgebung kann ein Anwender 11 ein Steuerungsprogramm auf der Datenverarbeitungsanlage 10 projektieren, welches anschließend auf eine Speicherprogrammierbare Steuerung (SPS) 12 geladen werden kann. Das Steuerungsprogramm wird innerhalb der Entwicklungsumgebung in Form eines Blockdiagramms implementiert.

Ein derartiges Blockdiagramm ist aus einer Vielzahl von Funktionsblöcken aufgebaut. Um dem Anwender 11 die zum Teil sehr komplexe Funktionalität der einzelnen Blöcke zu erläutern, ist auf der Datenverarbeitungsanlage 10 ein Computerprogramm zur Bereitstellung entsprechender Benutzerinformationen installiert. Das Computerprogramm ermöglicht dem Anwender 11, die Funktionalität der einzelnen Blöcke durch ausprobieren zu erlernen. Hierzu stellt das Computerprogramm ein Verfahren zur Verfügung, welches analog zu dem unter FIG 1 beschriebenen Verfahren zu jeder funktionalen Einheit des Programms eine Demonstrationsapplikation bereithält, anhand derer der Anwender die Funktion der einzelnen Blöcke durch Ausprobieren erlernen kann.

Nachdem der Anwender 11 auf der Datenverarbeitungsanlage 10 ein Blockdiagramm zur Steuerung einer Anlage entworfen hat, kann dieses auf der Datenverarbeitungsanlage 10 simuliert werden, um die korrekte Funktionalität des Programms zu überprüfen. Anschließend kann auf der Datenverarbeitungsanlage 10 ein entsprechendes Steuerungsprogramm aus dem Blockdiagramm generiert werden, welches anschließend auf die SPS 12 geladen wird.

Die vorliegende Erfindung soll nicht auf die hier exemplarisch gezeigten Ausführungsformen beschränkt sein. Vielmehr sind weitere Ausführungsformen denkbar und von der Erfindung umfasst, solange der Grundgedanke, dass dem Anwender 11 Benutzerinformationen zu funktionalen Einheiten in Form einer von dem Anwender 11 modifizierbaren Demonstrationsapplikation zur Verfügung gestellt werden, erhalten bleibt. Das vorgeschlagene erfindungsgemäße Verfahren ist nicht nur für die Anwendung innerhalb einer Programmierumgebung geeignet. Ebenso kann das Verfahren in reinen Simulationsprogrammen Anwendung finden. Beispiele hierfür sind Schaltungs- oder Systemsimulationsumgebungen, bei denen ein Anwender ein elektrisches Schaltbild oder ein regelungstechnisches Blockschaltbild in Form von einzelnen funktionalen Einheiten aufbaut.

## Patentansprüche

1. Verfahren zur Bereitstellung von Benutzerinformationen innerhalb einer softwarebasierten Entwicklungsumgebung zum Entwurf von aus funktionalen Einheiten (1) aufgebauten Schaltungen und/oder Systemen mit folgenden Verfahrensschritten:
- Erkennen einer von einem Anwender (11) selektierten funktionalen Einheit (1),
- Darstellung einer Demonstrationsapplikation (6), innerhalb derer die selektierte funktionale Einheit (1) enthalten ist,
- Simulation der Demonstrationsapplikation (6) und
- Visualisierung der Simulationsergebnisse (7).

2. Verfahren nach Anspruch 1,
wobei die softwarebasierte Entwicklungsumgebung zum Entwurf elektrischer, elektronischer und/oder logischer Schaltungen vorgesehen ist.

3. Verfahren nach Anspruch 1 oder 2,
wobei die softwarebasierte Entwicklungsumgebung zum Entwurf von Steuerungen und/oder Regelungen vorgesehen ist.

4. Verfahren nach einem der Ansprüche 1 bis 3,
wobei vor einem Start der Simulation ein Dialogfenster geöffnet wird, innerhalb dessen der Anwender den Wert mindestens eines Parameters modifizieren kann, der Einfluss auf die Simulationsergebnisse hat.

5. Verfahren nach Anspruch 4,
wobei der Parameter das Verhalten der selektierten funktionalen Einheit beeinflusst.

6. Verfahren nach einem der vorhergehenden Ansprüche,
wobei die selektierte funktionale Einheit (1) über Ein- und/oder Ausgänge mit weiteren funktionalen Einheiten in der Demonstrationsapplikation verbunden ist, wobei die Zustände der Ein- und/oder Ausgänge während und/oder nach der Simulation visualisiert werden.

7. Verfahren nach einem der vorhergehenden Ansprüche,
wobei die Demonstrationsapplikation durch den Anwender insbesondere durch hinzufügen und/oder entfernen der funktionalen Einheiten und/oder durch Zustandsänderungen an Eingängen der funktionalen Einheiten modifizierbar ist.

8. Verfahren nach einem der vorhergehenden Ansprüche,
wobei bei der Darstellung der Demonstrationsapplikation (6) und/oder bei der Visualisierung der Simulationsergebnisse (7) eine text- und/oder grafikbasierte Erläuterung zu der selektierten funktionalen Einheit (1) angezeigt wird.

9. Verfahren nach einem der vorhergehenden Ansprüche,
wobei die selektierte funktionale Einheit (1) ein inhärenter Bestandteil der Entwicklungsumgebung ist.

10. Verfahren nach einem der vorhergehenden Ansprüche,
wobei die selektierte funktionale Einheit (1) eine benutzerdefinierte funktionale Einheit ist, die insbesondere aus weiteren funktionalen Einheiten aufgebaut ist, die inhärente Bestandteile der Entwicklungsumgebung sind.

11. Computerprogrammprodukt zur Durchführung eines Verfahrens nach einem der Ansprüche 1 bis 10.

12. System zur Bereitstellung von Benutzerinformationen mit einem Speicher für eine softwarebasierte Entwicklungsumgebung zum Entwurf von aus funktionalen Einheiten (1) aufgebauten Schaltungen und/oder Systemen, wobei das System
- Mittel zum Erkennen einer von einem Anwender (11) selektierten funktionalen Einheit (1),
- Mittel zur Darstellung einer Demonstrationsapplikation (6), innerhalb derer die selektierte funktionale Einheit (1) enthalten ist,
- Mittel zur Simulation der Demonstrationsapplikation (6) und
- Mittel zur Visualisierung der Simulationsergebnisse (7) aufweist.

13. System nach Anspruch 12,
wobei das System zum Entwurf elektrischer, elektronischer und/oder logischer Schaltungen vorgesehen ist.

14. System nach Anspruch 12 oder 13,
wobei das System zum Entwurf von Steuerungen und/oder Regelungen vorgesehen ist.

15. Verfahren nach einem der Ansprüche 12 bis 14,
wobei das System Mittel zum Öffnen eines Dialogfensters vor einem Start der Simulation aufweist, innerhalb dessen der Anwender den Wert mindestens eines Parameters modifizieren kann, der Einfluss auf die Simulationsergebnisse hat.

16. Verfahren nach einem der Ansprüche 12 bis 15,
wobei der Parameter das Verhalten der selektierten funktionalen Einheit beeinflusst.

17. System nach einem der Ansprüche 12 bis 16,
wobei die selektierte funktionale Einheit (1) über Ein- und/oder Ausgänge mit weiteren funktionalen Einheiten in der Demonstrationsapplikation (6) verbunden ist, wobei Mittel zur Visualisierung der Simulationsergebnisse (7) derart ausgeprägt sind, dass die Zustände der Ein- und/oder Ausgänge während und/oder nach der Simulation visualisiert werden.

18. System nach einem der Ansprüche 12 bis 17,
wobei die Demonstrationsapplikation durch den Anwender insbesondere durch hinzufügen und/oder entfernen der funktionalen Einheiten und/oder durch Zustandsänderungen an Eingängen der funktionalen Einheiten modifizierbar ist.

19. System nach einem der Ansprüche 12 bis 18,
wobei das System Mittel zur Anzeige einer text- und/oder grafikbasierten Erläuterung zu der selektierten funktionalen Einheit bei der Darstellung der Demonstrationsapplikation (6) und/oder bei der Visualisierung der Simulationsergebnisse (7) aufweist.

20. System nach einem der Ansprüche 12 bis 19,
wobei das System die selektierte funktionale Einheit (1) als inhärenten Bestandteil der Entwicklungsumgebung aufweist.

21. System nach einem der Ansprüche 12 bis 20,
wobei die selektierte funktionale Einheit (1) eine benutzerdefinierte funktionale Einheit ist, die insbesondere aus weiteren funktionalen Einheiten aufgebaut ist, die inhärente Bestandteile der Entwicklungsumgebung sind.
